# DEMANDE DE BREVET EUROPEEN

(11) **EP 4 344 065 A1**
(43) Date de publication de la demande: **27.03.2024**
(21) Numéro de dépôt: 23197027.8
(22) Date de dépôt: 13.09.2023
(51) Int. Cl.: H03K 17/082

(54) **CIRCUIT DE COMMANDE D'UN TRANSISTOR**

(30) Priorité: 26.09.2022 FR 2209711
(71) Demandeur: STMicroelectronics (Tours) SAS, 37100 Tours (FR)
(72) Inventeur: SIMONNET, Jean-Michel, 37270 VERETZ (FR); GUITTON, Fabrice, 37380 MONNAIE (FR)
(74) Mandataire: Cabinet Beaumont

(57) **Abrégé**

La présente description concerne un circuit de commande (100) d'un premier transistor (150) comprenant :
- une diode de suppression de tensions transitoires (D1) dont la cathode est adaptée à être reliée à une première borne de conduction du premier transistor (150), et dont l'anode est reliée à un premier noeud (A) ;
- une première résistance (R2) adaptée à relier le premier noeud (A) à une borne de commande du premier transistor (150) ;
- un deuxième transistor (T1) dont la borne de commande est reliée au premier noeud (A), dont une première borne de conduction est adaptée à recevoir une première tension d'alimentation (VCC), et dont une deuxième borne de conduction est adaptée à être reliée à la borne de commande du premier transistor (150),
dans lequel la tension d'alimentation (VCC) est inférieure à 20 V.

## Description

### Domaine technique

La présente description concerne de façon générale les systèmes et dispositifs électroniques, et de façon plus particulière les systèmes et dispositifs électroniques utilisant un ou plusieurs transistors. La présente description concerne plus précisément un circuit de commande d'un transistor utilisant des composants actifs et passifs.

### Technique antérieure

Parmi les différentes méthodes existantes permettant de protéger un composant électronique contre des pics de tension, l'utilisation d'un circuit de commande comprenant un dispositif de suppression de tensions transitoires, ou dispositif TVS (Transient Voltage Suppressor), est une méthode répandue et employée pour la protection de composants électroniques, notamment de transistors.

Un exemple de dispositif TVS est une diode de suppression de tensions transitoires, également appelée diode TVS. Il s'agit d'une diode réalisée dans un matériau semiconducteur qui limite les surtensions par effet avalanche dans le but de protection d'un circuit électronique.

Il serait souhaitable de pouvoir améliorer, au moins en partie, certains aspects des circuits de commande de transistors connus.

### Résumé de l'invention

Il existe un besoin pour des circuits de commande de transistor plus performants.

Il existe un besoin pour des circuits de commande transistor plus performants, et comprenant une diode de suppression de tensions transitoires.

Il existe un besoin pour des circuits de commande transistor plus performants, et comprenant une diode de suppression de tensions transitoires et des composants actifs.

Un mode de réalisation pallie tout ou partie des inconvénients des circuits de commande de transistor connus.

Un mode de réalisation prévoit un circuit de commande d'un premier transistor comprenant :
- une diode de suppression de tensions transitoires dont la cathode est adaptée à être reliée à une première borne de conduction du premier transistor , et dont l'anode est reliée à un premier noeud ;
- une première résistance adaptée à relier le premier noeud à une borne de commande du premier transistor ;
- un deuxième transistor dont la borne de commande est reliée au premier noeud, dont une première borne de conduction est adaptée à recevoir une première tension d'alimentation, et dont une deuxième borne de conduction est adaptée à être reliée à la borne de commande du premier transistor, dans lequel la tension d'alimentation est inférieure à 20 V.

Selon un mode de réalisation, le circuit comprend, en outre, une diode redresseuse dont l'anode est reliée à la deuxième borne de conduction du deuxième transistor, et dont la cathode est adaptée à être reliée à la borne de commande du premier transistor .

Selon un mode de réalisation, le deuxième transistor est un transistor de type MOS.

Selon un mode de réalisation, le deuxième transistor est un transistor de type bipolaire.

Selon un mode de réalisation, la diode de suppression de tensions transitoires a une tension de claquage supérieure à 20 V.

Selon un mode de réalisation, la diode de suppression de tensions transitoires a une tension de claquage de l'ordre de 580 V.

Selon un mode de réalisation, la première résistance a une résistance de l'ordre de 10 Ohm.

Selon un mode de réalisation, le circuit comprend, en outre, une deuxième résistance dont une première borne est reliée à l'anode de la diode de suppression de tensions transitoires, et dont une deuxième borne est reliée au premier noeud.

Selon un mode de réalisation, le circuit comprend, en outre, une troisième résistance dont une première borne est reliée à la première borne de conduction du deuxième transistor, et dont une deuxième borne est reliée à un deuxième noeud adapté à recevoir la première tension d'alimentation.

Selon un mode de réalisation, le circuit comprend, en outre, un condensateur dont une première borne est reliée au deuxième noeud adapté à recevoir la première tension d'alimentation, et dont la deuxième borne est reliée à un troisième noeud adapté à recevoir une tension de référence.

Selon un mode de réalisation, la tension de référence est la masse.

Selon un mode de réalisation, le premier transistor est adapté à recevoir entre ses bornes de conduction une tension supérieur à 20 V.

Selon un mode de réalisation, le premier transistor est un transistor de type MOS.

Selon un mode de réalisation, le premier transistor est un transistor de type bipolaire.

Selon un mode de réalisation, le premier transistor est un transistor de type bipolaire à grille isolée.

Un autre mode de réalisation prévoit un circuit d'alimentation pour un moteur électrique triphasé comprenant au moins un troisième transistor et au moins un circuit de commande décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un schéma électronique d'un mode de réalisation d'un circuit de commande d'un transistor ;
la figure 2 comprend six vues illustrant chacune le fonctionnement du mode de réalisation de la figure 1 ; et
la figure 3 représente un exemple d'application pratique du mode de réalisation de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

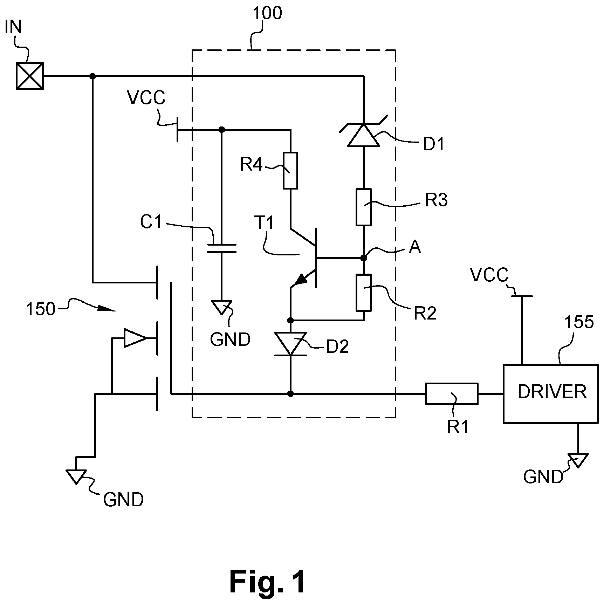

La figure 1 représente un schéma électrique d'un mode de réalisation d'un circuit de commande 100, délimité en figure 1 par une ligne pointillée, d'un transistor 150. La figure 1 représente, en outre, un circuit de pilotage 155 (DRIVER) du transistor 150.

Selon un premier exemple, représenté en figure 1, le transistor 150 est un transistor à effet de champ à grille isolée, ou transistor de type MOSFET (Metal Oxide Semiconductor Field Effect Transistor), aussi appelé transistor de type MOS. De plus, et plus particulièrement, le transistor 150 est, dans le cas de la figure 1, un transistor de type MOS à canal N, aussi appelé transistor NMOS. Le transistor 150 comprend deux bornes de conduction et une borne de commande. Une première borne de conduction est la borne de drain du transistor 150, et est reliée, de préférence connectée, à un noeud d'entrée IN pouvant recevoir des surtensions, ou pics de tension. Une deuxième borne de conduction est la borne de source du transistor 150 et est reliée, de préférence connectée, à un noeud de référence GND adapté à recevoir une tension de référence, par exemple la masse. La borne de commande du transistor 150 est la borne de grille du transistor 150. Selon une variante à la portée de la personne du métier, le transistor 150 peut être un transistor MOS à canal P, aussi appelé transistor PMOS.

Selon un deuxième exemple, non représenté en figure 1, le transistor 150 est un transistor bipolaire, et plus particulièrement, un transistor bipolaire de type NPN. Comme précédemment, le transistor 150 comprend deux bornes de conduction et une borne de commande. Une première borne de conduction est la borne de collecteur du transistor 150, et est reliée, de préférence connectée, au noeud d'entrée IN. Une deuxième borne de conduction est la borne d'émetteur du transistor 150 et est reliée, de préférence connectée, au noeud de référence GND. La borne de commande du transistor 150 est la borne de base du transistor 150. Selon une variante à la portée de la personne du métier, le transistor 150 peut être un transistor bipolaire de type PNP.

Selon un troisième exemple, non représenté en figure 1, le transistor 150 est un transistor bipolaire à grille isolée, ou transistor de type IGBT (Insulated Gate Bipolar Transistor). Le transistor 150 comprend deux bornes de conduction et une borne de commande. Une première borne de conduction est la borne de collecteur du transistor 150, et est reliée, de préférence connectée, au noeud d'entrée IN. Une deuxième borne de conduction est la borne d'émetteur du transistor 150 et est reliée, de préférence connectée, au noeud de référence GND. La borne de commande du transistor 150 est la borne de grille du transistor 150.

Le circuit de pilotage 155 est optionnel ici mais représente un circuit permettant de piloter le transistor 150 lors de son fonctionnement normal, c'est-à-dire lorsque le noeud d'entrée IN reçoit une tension de valeur "classique" pour l'utilisation du transistor 150, c'est-à-dire une tension qui n'est pas qualifiée de surtension. Le circuit de pilotage 155 comprend, au moins, une borne d'alimentation recevant une tension d'alimentation VCC, une borne de référence recevant la tension de référence GND, et une borne de sortie fournissant une tension de commande à la borne de commande du transistor 150. Selon un exemple, la borne de sortie du circuit de pilotage 155 est reliée à la borne de commande du transistor 150 par l'intermédiaire d'une résistance R1. Selon un exemple, la tension d'alimentation VCC est comprise entre 2,5 et 20 V, par exemple de l'ordre de 5 V ou de l'ordre de 15 V, et la résistance R1 a une résistance de l'ordre de 5 Ohm.

Le circuit de commande 100 est un circuit de commande permettant de commander le transistor 150 lors de l'apparition d'une surtension conséquente au niveau de la borne d'entrée IN, la quantification de cette surtension est détaillée ci-après. Plus particulièrement, le circuit de commande 100 permet de rendre le transistor 150 passant dès l'apparition d'une surtension au niveau de la borne d'entrée IN. De plus, le circuit de commande 100 est un circuit de commande comportant un ou plusieurs composants actifs et passifs. Il peut aussi être appelé, circuit de commande actif 100, ou circuit de protection du transistor 150.

Le circuit de commande 100 comprend un dispositif de suppression de tensions transitoires, ou dispositif TVS (Transient Voltage Suppressor), et plus particulièrement une diode de suppression de tensions transitoires D1, aussi appelée diode TVS. Une diode TVS est une diode réalisée dans un matériau semiconducteur qui limite les surtensions par effet avalanche dans le but de protection d'un circuit électronique. La diode TVS D1 comprend une cathode reliée, de préférence connectée, à un noeud d'entrée du circuit de commande 100 correspondant au noeud IN, et une anode reliée à un noeud A. Selon un exemple, la diode TVS D1 est adaptée à être utilisée pour des hautes tensions, c'est-à-dire des tensions supérieures à 20 V, par exemple supérieures à 100 V, et a une tension de claquage ou d'écrêtage supérieure à 20 V, par exemple supérieure à 100 V, par exemple de l'ordre de 580 V. On appelle ici "surtension" reçue au niveau de la borne d'entrée IN, une tension supérieure à la tension d'écrêtage de la diode TVS D1.

Le circuit de commande 100 comprend, en outre, un transistor T1 comprenant deux bornes de conduction et une borne de commande. Une première borne de conduction est reliée à un noeud recevant la tension d'alimentation VCC, et une deuxième borne de conduction est reliée à la borne de commande du transistor 150. La borne de commande du transistor T1 est reliée, de préférence connectée, au noeud A. Selon une variante de réalisation, la première borne de conduction est reliée à un noeud recevant une tension d'alimentation VCC' indépendante de la tension d'alimentation VCC. Plus particulièrement, la tension d'alimentation VCC' peut être indépendante de la tension d'alimentation VCC, et être inférieure à la tension d'alimentation VCC.

Selon un premier exemple, représenté en figure 1, le transistor T1 est un transistor bipolaire de type NPN. Dans ce cas, la première borne de conduction du transistor T1 est sa borne de collecteur, et la deuxième borne de conduction du transistor T1 est sa borne d'émetteur. La borne de commande est donc sa borne de base. Selon une variante de réalisation à la portée de la personne du métier, le transistor T1 peut être un transistor bipolaire de type PNP.

Selon un premier exemple, non représenté en figure 1, le transistor T1 est un transistor NMOS. Dans ce cas, la première borne de conduction du transistor T1 est sa borne de drain, et la deuxième borne de conduction du transistor T1 est sa borne de source. La borne de commande est donc sa borne de grille. Selon une variante de réalisation à la portée de la personne du métier, le transistor T1 peut être un transistor PMOS.

Le circuit de commande 100 comprend, en outre, une résistance R2 disposée entre la borne de commande et la deuxième borne de conduction du transistor T1. Selon un exemple, la résistance R2 a une résistance comprise entre 5 et 100 Ohm, par exemple de l'ordre de 10 Ohm.

Le circuit de commande 100 comprend, en outre, une diode redresseuse D2 dont l'anode est reliée à la deuxième borne de conduction du transistor T1, et dont la cathode est adaptée à être reliée à la borne de commande du transistor 150. La diode redresseuse D2 permet d'empêcher un courant de commande du transistor 150, délivré par le circuit de pilotage 155, de circuler dans le circuit de commande 100.

Le circuit de commande 100 comprend, en outre et de manière optionnelle, deux résistances R3 et R4 et un condensateur C1. La résistance R3 est disposée entre l'anode de la diode TVS D1 et la borne de commande du transistor T1. Selon un exemple, la résistance R3 a une résistance comprise entre 0 et 100 Ohm, par exemple de l'ordre de 0, 50 ou 100 Ohm. Selon un exemple, la résistance R4 est disposée entre le noeud recevant la tension d'alimentation VCC et la première borne de conduction du transistor T1. Selon un exemple, la résistance R4 a une résistance comprise entre 0 et 20 Ohm, par exemple de l'ordre de 10 Ohm. Le condensateur C1 est un condensateur de filtrage disposée entre le noeud recevant la tension d'alimentation VCC et le noeud de référence GND. Selon un exemple, le condensateur C1 a une capacité comprise entre 50 nF et 100 µF, par exemple de l'ordre de 100 nF.

Le fonctionnement du circuit de commande est le suivant. Lorsqu'un pic de tension, ou une surtension, survient au niveau du noeud d'entrée IN et est supérieure à la tension d'écrêtage de la diode TVS D1, la diode TVS D1 devient passante, et fournit une tension permettant de rendre passant le transistor T1. La valeur de cette tension, et donc la sensibilité de détection du transistor T1, peuvent être ajustées grâce à la résistance R2, et, le cas échéant, la résistance R3. Le transistor T1 étant passant, il permet de fournir à la borne de commande du transistor 150 la tension d'alimentation qui est dimensionnée, par exemple par l'intermédiaire de la résistance R4, pour rendre le transistor 150 passant. Ainsi, quand une surtension survient, la puissance électrique qu'elle amène est dissipée, principalement, par le transistor 150 et par la diode TVS pour le circuit de commande, mais aussi en partie par le transistor T1. C'est un avantage, en effet, dans un circuit de commande de transistor plus classique, c'est-à-dire dans un circuit de commande où une diode TVS est utilisée seule pour dissiper totalement la puissance électrique amenée par une surtension, la diode TVS, si la surtension reçue est trop élevée, peut être abimée par la puissance à dissiper.

Une autre solution pour éviter d'abimer une diode TVS dans ce cas aurait été d'utiliser une diode TVS ayant une surface plus grande permettant de dissiper une plus grande puissance électrique. Un autre avantage du mode de réalisation de la figure 1 est donc de permettre d'avoir une diode TVS ayant une surface plus petite, et donc de minimiser l'encombrement du circuit de commande 100.

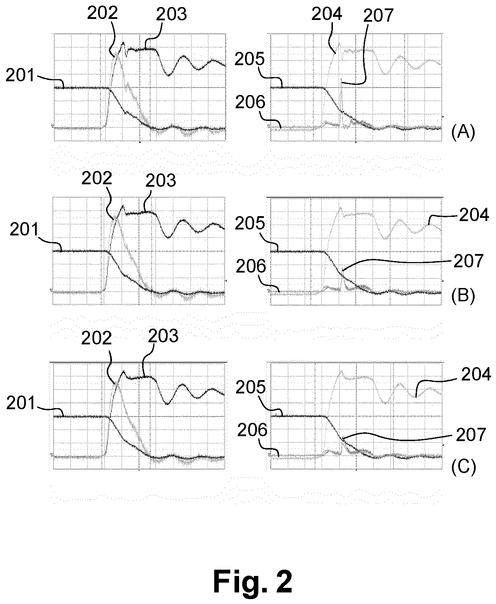

La figure 2 comprend trois vues (A), (B) et (C) comportant chacune deux graphiques permettant d'illustrer le fonctionnement du circuit de commande 100 décrit en relation avec la figure 1.

Chaque vue (A), (B), et (C), comprend sur son graphique de gauche en figure 2, les courbes suivantes :
- une courbe 201 représentant l'évolution temporelle du courant entre les bornes de conduction du transistor 150 ;
- une courbe 202 représentant l'évolution temporelle de la puissance dissipée par le transistor 150 ; et
- une courbe 203 représentant l'évolution temporelle de la tension entre les deux bornes de conduction du transistor 150.

Chaque vue (A), (B), et (C), comprend sur son graphique de droite en figure 2 les courbes suivantes :
- une courbe 204 représentant l'évolution temporelle de la tension aux bornes de la diode TVS D1, des résistances R3 et R2 et de la diode D2 ;
- une courbe 205 représentant l'évolution temporelle du courant au niveau de la borne de source du transistor 150 ;
- une courbe 206 représentant l'évolution temporelle du courant traversant la diode TVS D1 ; et
- une courbe 207 représentant l'évolution temporelle de la puissance dissipée par la diode TVS D1, la diode D2 et les résistances R2 et R3.

Les mesures qui ont été réalisées pour obtenir les graphiques des vues (A), (B), et (C) ont été effectuées en prenant les valeurs numériques suivantes :
- la tension d'écrêtage de la diode TVS égale à 640 V pour la mesure de la vue (A), et égale à 645 V pour la mesure de la vue (B) et 649 V pour la mesure de la vue (C) ;
- la tension d'alimentation VCC égale à 5 V pour toutes les mesures ;
- la résistance de la résistance R2 égale à 10 Ohm pour toutes les mesures ;
- la résistance de la résistance R3 égale à 0 Ohm pour la mesure de la vue (A), égale à 50 Ohm pour la mesure de la vue (B), et égale à 100 Ohm pour la mesure de la vue (C) ;
- la résistance de la résistance R4 égale à 10 Ohm pour toutes les mesures ; et
- la capacité du condensateur C1 égale à 100 nF pour toutes les mesures.

De plus, pour toutes les mesures, la surtension envoyée sur le noeud d'entrée IN a été produite par un circuit inductif comprenant, en série entre les noeuds IN et GND, une source de tension délivrant une tension de l'ordre de 460 V et permettant de charger un condensateur ayant une capacité de l'ordre de 10 µF, une bobine ayant une inductance de l'ordre de 1 µH, et une résistance ayant une résistance de l'ordre de 15 Ohm.

Ces mesures ont permis de montrer que grâce à cette invention, la puissance électrique dissipée par la diode TVS D1 a été divisée par un coefficient compris entre 3 et 5, par comparaison avec un circuit classique utilisant une diode TVS en série avec une diode, c'est-à-dire un circuit dans lequel une diode TVS est disposée entre la borne de commande du transistor 150 et sa première borne de conduction.

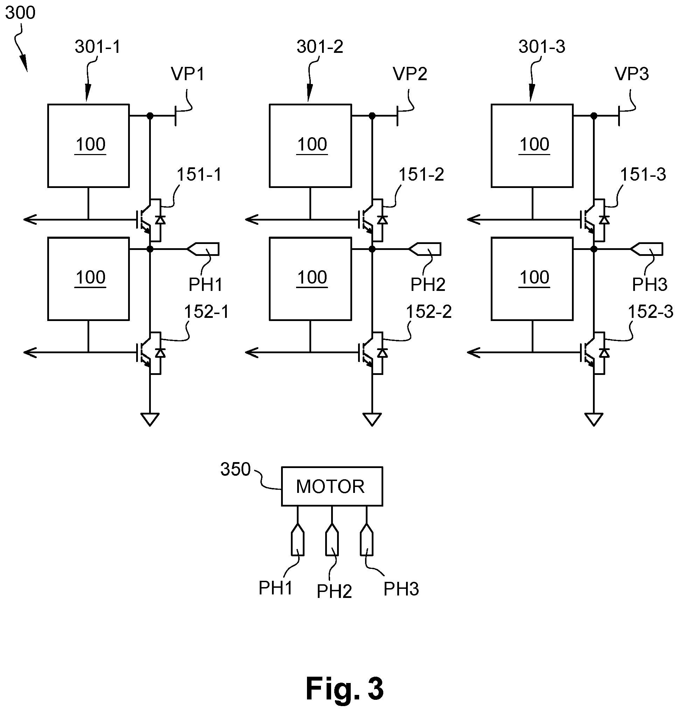

La figure 3 représente, schématiquement et partiellement sous forme de blocs, un exemple d'application du mode de réalisation décrit en relation avec la figure 1. Plus particulièrement, la figure 3 illustre une partie d'un circuit d'alimentation 300 d'un moteur électrique triphasé 350 (MOTOR).

Le circuit d'alimentation 300 est adapté à fournir un courant triphasé au moteur 350, pour cela le circuit d'alimentation comprend trois sorties PH1, PH2 et PH3 fournissant chacune, par alternance, un courant ayant une phase différente. Pour mettre en oeuvre ce système d'alternance chaque sortie PH1, PH2, PH3 est, respectivement, reliée à une source de tension VP1, VP2, VP3 par l'intermédiaire d'un interrupteur de puissance 151-1, 151-2, 151-3, et à un noeud recevant un potentiel de référence, par exemple la masse, par l'intermédiaire d'un interrupteur de puissance 152-1, 152-2, 152-3. Ces interrupteurs de puissance 151-1, 151-2, 151-3, 152-1, 152-2, et 152-3 sont généralement des transistors du type des transistors 150 décrits en relation avec la figure 1. En figure 3, les interrupteurs de puissance 151-1, 151-2, 151-3, 152-1, 152-2, et 152-3 sont des transistors de type IBGT.

Selon un mode de réalisation, chaque interrupteur 151-1, 151-2, 151-3, 152-1, 152-2, 152-3 est associé à un circuit de commande 100 décrit en relation avec la figure 1.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit de commande (100) d'un premier transistor (150 ; 151-1, 151-2, 151-3, 152-1, 152-2, 152-3) comprenant :
- une diode de suppression de tensions transitoires (D1) dont la cathode est adaptée à être reliée à une première borne de conduction du premier transistor (150 ; 151-1, 151-2, 151-3, 152-1, 152-2, 152-3), et dont l'anode est reliée à un premier noeud (A) ;
- une première résistance (R2) adaptée à relier le premier noeud (A) à une borne de commande du premier transistor (150 ; 151-1, 151-2, 151-3, 152-1, 152-2, 152-3) ;
- un deuxième transistor (T1) dont la borne de commande est reliée au premier noeud (A), dont une première borne de conduction est adaptée à recevoir une première tension d'alimentation (VCC), et dont une deuxième borne de conduction est adaptée à être reliée à la borne de commande du premier transistor (150 ; 151-1, 151-2, 151-3, 152-1, 152-2, 152-3),
dans lequel la tension d'alimentation (VCC) est inférieure à 20 V.

2. Circuit selon la revendication 1, comprenant, en outre, une diode redresseuse (D2) dont l'anode est reliée à la deuxième borne de conduction du deuxième transistor (T1), et dont la cathode est adaptée à être reliée à la borne de commande du premier transistor (150 ; 151-1, 151-2, 151-3, 152-1, 152-2, 152-3).

3. Circuit selon la revendication 1 ou 2, dans lequel le deuxième transistor (T1) est un transistor de type MOS.

4. Circuit selon la revendication 1 ou 2, dans lequel le deuxième transistor (T1) est un transistor de type bipolaire.

5. Circuit selon l'une quelconque des revendications 1 à 4, dans lequel la diode de suppression de tensions transitoires (D1) a une tension de claquage supérieure à 20 V.

6. Circuit selon la revendication 5, dans lequel la diode de suppression de tensions transitoires (D1) a une tension de claquage de l'ordre de 580 V.

7. Circuit selon l'une quelconque des revendications 1 à 6, dans lequel la première résistance (R2) a une résistance de l'ordre de 10 Ohm.

8. Circuit selon l'une quelconque des revendications 1 à 7, comprenant, en outre, une deuxième résistance (R3) dont une première borne est reliée à l'anode de la diode de suppression de tensions transitoires (D1), et dont une deuxième borne est reliée au premier noeud (A).

9. Circuit selon l'une quelconque des revendications 1 à 8, comprenant, en outre, une troisième résistance (R4) dont une première borne est reliée à la première borne de conduction du deuxième transistor (T1), et dont une deuxième borne est reliée à un deuxième noeud adapté à recevoir la première tension d'alimentation (VCC).

10. Circuit selon l'une quelconque des revendications 1 à 9, comprenant, en outre, un condensateur (C1) dont une première borne est reliée au deuxième noeud adapté à recevoir la première tension d'alimentation (VCC), et dont la deuxième borne est reliée à un troisième noeud (GND) adapté à recevoir une tension de référence.

11. Circuit selon la revendication 10, dans lequel la tension de référence est la masse.

12. Circuit selon l'une quelconque des revendications 1 à 11, dans lequel le premier transistor (150 ; 151-1, 151-2, 151-3, 152-1, 152-2, 152-3) est adapté à recevoir entre ses bornes de conduction une tension supérieur à 20 V.

13. Circuit selon l'une quelconque des revendications 1 à 12, dans lequel le premier transistor (150 ; 151-1, 151-2, 151-3, 152-1, 152-2, 152-3) est un transistor de type MOS.

14. Circuit selon l'une quelconque des revendications 1 à 12, dans lequel le premier transistor (150 ; 151-1, 151-2, 151-3, 152-1, 152-2, 152-3) est un transistor de type bipolaire.

15. Circuit selon l'une quelconque des revendications 1 à 12, dans lequel le premier transistor (150 ; 151-1, 151-2, 151-3, 152-1, 152-2, 152-3) est un transistor de type bipolaire à grille isolée.

16. Circuit selon l'une quelconque des revendications 1 à 15, dans lequel la tension d'alimentation (VCC') est inférieure à une tension d'alimentation (VCC) d'un circuit de pilotage dudit premier transistor (150 ; 151-1, 151-2, 151-3, 152-1, 152-2, 152-3).

17. Circuit d'alimentation pour un moteur électrique triphasé comprenant au moins un troisième transistor (150 ; 151-1, 151-2, 151-3, 152-1, 152-2, 152-3) et au moins un circuit de commande selon l'une quelconque des revendications 1 à 15.
